Europäisches Patentamt

European Patent Office

Office européen des brevets

(19)

(11) **EP 0 635 725 B1**

(12) **FASCICULE DE BREVET EUROPEEN**

(45) Date de publication et mention
de la délivrance du brevet:
**12.06.2002 Bulletin 2002/24**

(51) Int Cl.⁷: **G01R 19/155**

(21) Numéro de dépôt: **94410052.8**

(22) Date de dépôt: **20.07.1994**

(54) **Dispositif électronique pour vérifier la présence de tension et comparer la phase dans des conducteurs de lignes électriques**

Elektronische Schaltung zur Kontrolle der Anwesenheit von Spannungen in elektrischen Leitungen und zum Vergleichen deren Phasenlage

Electronic circuit for monitoring the presence of a voltage and for comparing the phase in conductors of electric lines

(84) Etats contractants désignés:
**DE ES FR GB SE**

(30) Priorité: **22.07.1993 IT MI931625**

(43) Date de publication de la demande:
**25.01.1995 Bulletin 1995/04**

(73) Titulaire: **Schneider Electric Industries SA**
**92500 Rueil-Malmaison (FR)**

(72) Inventeur: **Perli, Giorgio, Schneider Electric SA**
**F-38050 Grenoble Cedex 09 (FR)**

(74) Mandataire: **Hecké, Gérard et al**
**Schneider Electric SA,**
**Sce. Propriété Industrielle**
**38050 Grenoble Cédex 09 (FR)**

(56) Documents cités:
**EP-A- 0 402 277        DE-A- 3 727 950**
**DE-A- 4 032 689        DE-A- 4 109 943**
**FR-A- 2 627 287**

• **PATENT ABSTRACTS OF JAPAN vol. 007, no. 198 (P-220), 2 Septembre 1983 & JP 58 097664 A (MITSUBISHI DENKI KK), 10 Juin 1983**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

# EP 0 635 725 B1

## Description

La présente invention concerne un dispositif électronique pour vérifier, à une distance de sécurité, la présence de tension et le déphasage de tension dans des conducteurs de lignes électriques à courant alternatif, comprenant:

- au moins deux dispositifs capacitifs couplés à aux moins deux desdits conducteurs électriques, chaque dispositif capacitif fournissant un courant alternatif à très basse intensité ayant la même fréquence que le signal de tension du conducteur auquel il est couplé,
- des circuits de détection de phase auto alimentés, chaque circuit étant connecté à un desdits dispositifs capacitifs associé, et fournissant une impulsion lumineuse pour chaque période du signal provenant dudit dispositif capacitif associé.
- des câbles à fibres optiques comportant chacun une première extrémité reliée à un desdits circuits de détection de phase, aptes à transmettre lesdites impulsions lumineuses dans une zone de sécurité, éloignée des conducteurs électriques; et
- au moins un dispositif de comparaison du déphasage, connecté à des secondes extrémité desdits câbles à fibres optiques, pour comparer des impulsions lumineuses émises par deux différents circuits détecteurs de phases,

Un tel dispositif est décrit dans le document DE-A-3 727 950.

Il arrive fréquemment, dans des interventions ordinaires de gestion et de manutention des lignes électriques moyennes ou haute tension, que l'opérateur doive accéder aux cabines pour connecter ou déconnecter des tronçons de ligne. Pour effectuer ces opérations, il est nécessaire de vérifier préventivement si lesdits tronçons de lignes sont au moins sous tension et déterminer quels sont les conducteurs de chaque tronçon de ligne en phase, de manière à éviter des connexions erronées ou inefficaces.

Pour prélever sur les conducteurs moyenne tension un signal adapté pour faire lesdites vérifications, on utilise en général des couplages capacitifs. Si la capacité de tels couplages est suffisamment élevée, le courant fourni par les couplages est suffisant pour alimenter en continu de manière visible une lampe à décharge. Toutefois, avec des couplages capacitifs à capacité élevée (avec de grandes superficies d'armatures ou de petites distances d'isolement par rapport au conducteur), les contraintes sur le diélectrique du couplage ainsi que les possibilités de perforation augmentent. Le dispositif de vérification devient ainsi moins fiable aussi bien du point de vue du fonctionnement que de celui de la sécurité.

Pour améliorer la sécurité et l'agencement du dispositif de vérification, notamment dans les tableaux électriques isolés au gaz, on s'est dirigé dans les dernières années vers l'adoption de couplages capacitifs à capacité très basse, par exemple constitués par de simples anneaux disposés autour de conducteurs en entrée et en sortie des tableaux. Ce type de couplage présente une fiabilité très supérieure à celle des couplages à haute capacité, et a aussi l'avantage d'un coût sensiblement inférieur; mais il n'est capable de fournir que de très bas courants, de l'ordre de quelques dizaines de micro ampères.

Des courants de cet ordre de grandeur ne peuvent pas être utilisés directement pour provoquer l'allumage d'une lampe à décharge qui soit bien visible à l'opérateur. Pour cette raison, selon une technique connue, l'énergie d'un tel courant à basse intensité est accumulée dans un condensateur. Ensuite l'énergie stockée dans le condensateur est déchargée périodiquement - lorsque la charge du condensateur a atteint un niveau adéquat - sur une lampe à décharge adaptée, provoquant l'allumage en mode intermittent

Avec un système analogue on peut procéder aussi à la vérification de la concordance de phases entre les conducteurs d'au moins deux tronçons de ligne. Dans ce cas, le circuit comprenant le condensateur et la lampe à décharge, est connecté directement entre les couplages capacitifs des deux conducteurs entre lesquels on veut vérifier la concordance de phase; si les deux conducteurs sont en phase, il ne circulera pas de courant dans le circuit et la lampe restera éteinte, par contre le courant circulera, provoquant l'allumage périodique de la lampe si, au contraire, les deux conducteurs ne sont pas en phase. Le même résultat peut s'obtenir aussi à l'aide de dispositifs électroniques adaptés, qui relèvent directement la concordance de phase des courants fournis par les couplages capacitifs qui lui sont électriquement connectés. Les couplages capacitifs sur les divers conducteurs peuvent être égaux entre eux, il n'y a évidemment aucune importance, pour la vérification de la concordance de phase, qu'il y ait un éventuel déphasage entre le signal du réseau et le signal issu du couplage capacitif.

Un tel système de vérification de la présence de tension et de comparaison de phase souffre toutefois de quelques inconvénients. En fait, même si les couplages capacitifs à basse capacité sont plus fiables concernant une éventuelle perforation de leur diélectrique, le risque d'une perforation reste possible par suite d'un effet de surtension sur le réseau. Il en résulte que la tension de la ligne se retrouve sur le dispositif accessible à l'opérateur. Pour éviter cet inconvénient, chaque élément extérieur comporte des déchargeurs de tension sur la partie basse tension du courant capacitif, ce qui provoque toutefois une complication et un coût plus élevé du système.

Un second inconvénient vient de l'emploi de couplages capacitifs à basse capacité obligeant à disposer le système de vérification dans le voisinage immédiat du conducteur. Dans le cas contraire, le courant à basse intensité venant du couplage capacitif serait entièrement absorbé par la seule capacité intrinsèque du câble de raccordement. L'usage du système comporte naturellement certaines incommodités pour l'opérateur.

Le document EP-A-402 277 décrit un indicateur de présence de tension ayant un voyant à diode LED commandée par un transistor unijonction programmable, lequel est associé à un circuit à seuil. Ce dernier comprend un diviseur résistif connecté en parallèle avec un condensateur basse tension à la sortie d'un diviseur capacitif. Un pont redresseur est inséré entre le condensateur haute tension, et la terre.

Un premier but de la présente invention est de disposer d'un dispositif pour la vérification de la présence de tension et la comparaison de phase de conducteurs de lignes électriques, apte à fonctionner avec des courants de l'ordre de quelques dizaines de micro ampères, dans lequel la partie accessible aux opérations de contrôle et de manutention ordinaire est isolée électriquement par rapport aux conducteurs de ligne et éloignée d'eux dans une zone de sécurité non traversée par des conducteurs métalliques.

Un second but de l'invention consiste à éloigner à volonté une telle zone de sécurité, par exemple à 10 mètres, de manière à pouvoir disposer la partie du dispositif destinée à être utilisée fréquemment par l'opérateur dans une zone facilement accessible de la cabine, par exemple à la hauteur du sol sans aucune conséquence négative ni pour l'opérateur ni pour une quelconque personne susceptible de se trouver dans le voisinage du dispositif.

Selon l'invention, de tels buts sont atteints par le fait que chaque circuit de détection de phase comporte:

- des moyens de redressement traversés par le courant fourni par les dispositifs capacitifs, et formant un pont redresseur à deux branches,
- un premier condensateur connecté dans l'une des branches entre deux moyens de redressement, et susceptible d'être chargé pendant la demi-période négative du courant d'entrée,
- un second condensateur connecté dans l'autre branche entre deux moyens de redressement, et susceptible d'être chargé pendant la demi-période positive du courant d'entrée,
- des moyens de contrôle pour activer, à un instant prédéterminé de la période dudit courant, la décharge d'au moins un desdits condensateurs à travers une diode électroluminescente, lesdits moyens de contrôle comprenant un thyristor connecté en série avec la diode électroluminescente aux bornes du premier condensateur, et un transistor unijonction branché entre le thyristor et l'une des bornes du second condensateur.

La décharge activée sur le premier desdits condensateurs active la décharge du second desdits condensateur au moyen dudit thyristor.

Selon un développement de l'invention, ledit dispositif de comparaison comporte:

- deux entrées,

- deux dispositifs photosensibles, reliés chacun à une entrée, pour transformer les impulsions lumineuses d'entrée en signaux électriques correspondants,

- deux multivibrateurs monostables, connectés aux dispositifs photosensibles, pour allonger la durée desdits signaux électriques correspondants,

- un circuit logique, connecté aux multivibrateurs monostables, pour obtenir un signal ayant une durée proportionnelle à la différence de phase desdits deux signaux,

- un stabilisateur, connecté au circuit logique, pour intégrer ledit signal représentatif de la différence de phase et fournir un signal continu, et

- un comparateur, connecté au stabilisateur, pour comparer ledit signal continu avec un seuil de référence.

D'autres avantages et caractéristiques ressortiront plus clairement de la description qui va suivre, de modes particuliers de réalisation de l'invention, donnés à titre d'exemples non limitatifs, et représentés aux dessins annexés, dans lesquels:

La figure 1 représente un schéma bloc d'un dispositif invention, comportant des circuits de détection de présence de tension de détection de phase et de comparaison de phase.

La figure 2 représente un schéma d'un circuit de détection de présence de tension pouvant être utilisé dans le dispositif de la figure 1.

La figure 3 représente un schéma d'un circuit de détection de phase pouvant être utilisé dans le dispositif de la figure 1.

La figure 4 représente un schéma bloc d'un circuit de comparaison de phase pouvant être utilisé dans le dispositif de la figure 1.

La figures 5 illustre schématiquement des diagrammes des signaux sortant de divers blocs et circuits de la figure 4.

Comme décrit précédemment, le but de la présente invention consiste à transformer le signal électrique en provenance de couplages capacitifs prévus sur des conducteurs électriques de la ligne en signaux lumineux. Lesdits signaux lumineux sont transportés aux moyens de câbles à fibres optiques au-delà d'une zone de sécurité et ensuite jusqu'à une zone d'accessibilité facile pour l'opérateur, où de tels signaux sont utilisés directement ou indirectement pour obtenir les informations désirées.

Pour obtenir ce résultat, la présente invention a résolu différents problèmes : d'une part, celui d'obtenir un premier signal lumineux représentatif de la présence d'un signal de tension du conducteur électrique sous contrôle, d'autre part celui d'obtenir un second signal lumineux représentatif de la phase du courant circulant dans ledit conducteur et ensuite apte à permettre la vérification de l'identité de phase de deux conducteurs. Ces opérations sont nécessaires avant d'effectuer la connexion électrique des conducteurs, et facilitées grâce à l'alimentation du dispositif par le courant à très basse intensité (quelques $\mu A$ à quelques dizaines de $\mu A$) émis par un dispositif d'alimentation capacitif couplé au conducteur lui-même. Les signaux lumineux doivent être en outre suffisamment intenses pour pouvoir être transmis de manière efficace à une distance convenable des conducteurs électriques (par exemple 5 à 10 mètres).

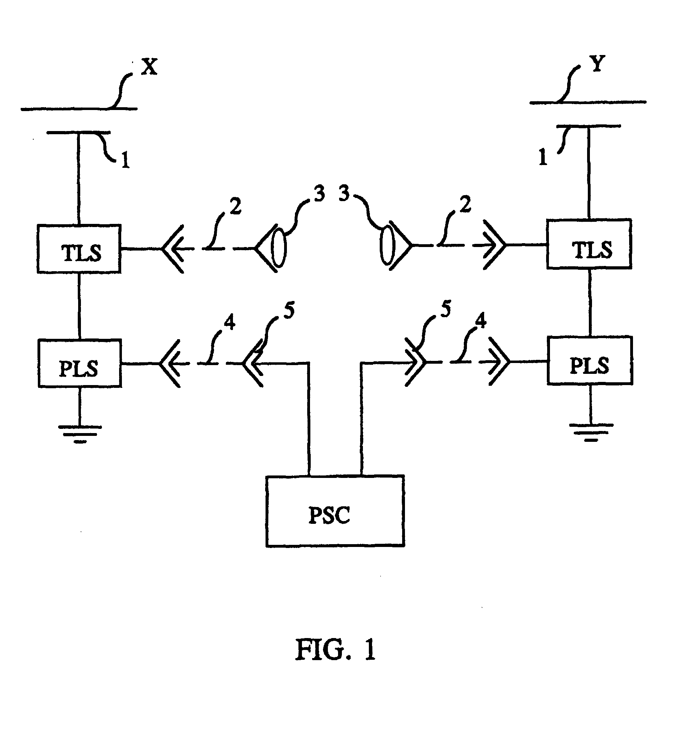

Un dispositif selon un mode de réalisation de l'invention est illustré dans le schéma bloc de la figure 1, dans lequel, par simplicité, seulement deux conducteurs actifs X et Y de deux différents tronçons de lignes électriques sont indiqués. Il est évident que des dispositifs analogues sont associés à d'autres conducteurs présents dans la cabine, sur lesquels doivent être exécutés les contrôles, objet de la présente invention.

A chaque terminaison des deux conducteurs X et Y de deux différents tronçons de ligne est associé un couplage capacitif 1 relié en série avec un circuit TLS de détection de présence tension, un circuit PLS de détection de phase et la terre. Le circuit TLS est destiné à émettre un signal lumineux intermittent, d'intensité suffisante pour pouvoir être facilement vu à l'oeil nu, lorsque le conducteur respectif est sous tension. Ce signal est transporté au moyen d'un câble à fibres optiques 2 jusqu'à un endroit accessible par l'opérateur, et rendu plus facilement perceptible avec une lentille de diffusion 3.

Le circuit PLS est par contre, destiné à émettre un signal lumineux représentatif de la phase du signal électrique généré par le couplage capacitif 1. Le signal lumineux est plus précisément un signal lumineux à émissions d'impulsions, une pour chaque période, en correspondance avec une zone bien déterminée étroite de la courbe sinusoïdale de tension, comme on le verra plus clairement par la suite. Ce même signal pourrait facilement être utilisé pour vérifier la présence de tension sur les conducteurs X ou Y, toutefois celui-ci est trop faible pour pouvoir être perçu visiblement et devrait ainsi être avantageusement amplifié. Le signal émis par le circuit PLS est donc transporté à l'endroit accessible par l'opérateur au moyen d'un câble à fibres optiques **4** avec un connecteur optique **5.**

Le dispositif selon la présente invention est complété par un dispositif PSC de comparaison de phase qui est connecté par l'opérateur aux connecteurs optiques 5 relatifs à deux conducteurs différents X et Y sur lesquels on veut vérifier la concordance de phase. Par la suite, les divers dispositifs qui comparent l'appareil de la présente invention seront décrits en détail.

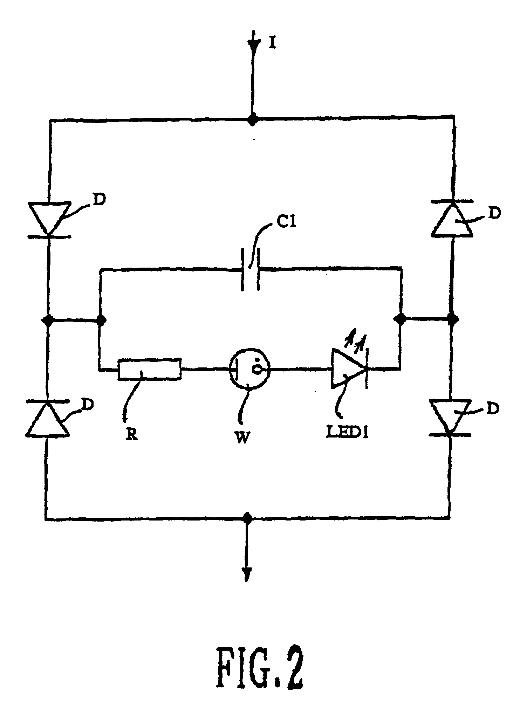

Le circuit TLS de détection de présence tension, représenté par le schéma de la figure 2, comporte un pont de diodes D, dont une première entrée alternative reçoit un courant I fourni par un coupleur capacitif 1 et une seconde entrée alternative connectée par exemple à un circuit de détection de phase permet la sortie du courant I. Un condensateur C1 est connecté entre la sortie positive et la sortie négative du pont de diodes. Un circuit série comprenant une résistance R, une lampe à décharge W et une diode électroluminescente LED1 est connecté en parallèle sur le condensateur C1.

Grâce au pont de diodes D, le courant I émis par le couplage capacitif 1 circule toujours dans le même sens, traversant le condensateur C1 sous la forme de courant redressé pulsé. Ledit condensateur se charge donc progressivement en n cycles successifs de courant jusqu'à ce qu'il atteigne une tension de décharge de la lampe W. Le courant de décharge, limité par la résistance R, provoque l'allumage de la lampe W et de la diode LED1. Puisque la très basse énergie du courant produit par le couplage capacitif 1 vient s'accumuler dans le condensateur C1 en n cycles, le courant de décharge du condensateur a une intensité suffisante, pour rendre un signal lumineux dans la diode LED1 clairement perceptible même à l'oeil nu. La valeur de la capacité du condensateur C1 et la caractéristique de la lampe W sont choisis en fonction du courant émis par le couplage capacitif 1, pour avoir de préférence au moins une décharge par seconde par la lampe W et sur la diode LED1.

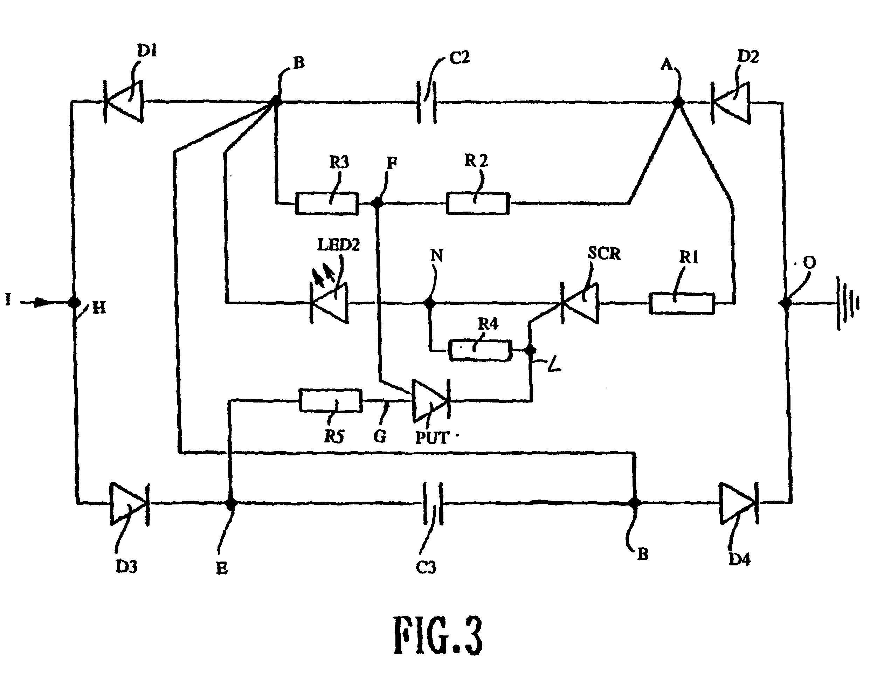

Le circuit PLS de détection de phase est représenté en détail sur la figure 3. Le courant I provenant du couplage capacitif 1 entre par une entrée H du circuit, et sort par une sortie O. Le circuit PLS de la figure 3 comporte deux branches OABH et HEBO principales où A, E et B sont des points particuliers du circuit. Une diode D1 est connectée entre le point B et l'entrée H, et un condensateur C2 est connecté d'une manière similaire entre les points A et B. Une diode D2 est branchée entre la sortie O et le point A, et une diode D3 est reliée entre l'entrée H et le point E. Un condensateur C3 est connecté entre les points E et B, et une diode D4 est connectée entre le point B et la sortie O. Le circuit série de la diode D2, du condensateur C2 et de la diode D1 forme la première branche OABH parcourue par la demi-période négative du courant I et la diode D3, le condensateur C3 et la diode D4 forment une seconde branche HEBO parcourue la demi-période positive du courant I, le point B étant commun aux anodes des diodes D1 et D4 et à une électrode de chacun des condensateurs C2 et C3.

Quand la branche OABH conduit, la tension sur le condensateur C2 augmente graduellement en fonction de l'intensité du courant I, de la capacité du condensateur C2 et de la valeur de la somme de deux résistances en série R2 et R3, mises en parallèle sur le condensateur C2. La tension sur le condensateur C2, divisée par le pont diviseur R2-R3 est répartie entre un point F, commun du pont R2-R3, et le points et B.

Lorsque le courant I s'inverse et commence la demi-période positive, il parcourt comme déjà dit la branche HEBO allant charger le condensateur C3 en fonction de sa propre valeur et de celle de la capacité du condensateur C3. Pendant la même demi-période, la charge sur le condensateur C2 diminue progressivement en fonction de la valeur de sa capacité et de celles des résistances R2 et R3, diminuant par conséquent la tension entre les points F et B.

Une résistance R1, un thyristor SCR et une diode électroluminescente LED2 connectés entre eux en série sont connectés entre le point A et le point B. Une résistance R4 de polarisation est connectée entre la gâchette du thyristor, correspondant à un point L, et un point N commun à la cathode du thyristor et à l'anode de la diode LED2. Un transistor unijonction PUT est connecté entre le point E, à travers une résistance R5 en série, et le point L, l'électrode de commande du transistor étant connectée au point F.

A un instant déterminé de la demi-période positive du courant I, la tension entre les points G et B devient supérieure à une valeur prédéterminée de la tension entre les points F et B.

Dans ces conditions le transistor PUT permet la décharge du condensateur C3 à travers le circuit EGLNBE. Le courant de cette décharge, limité par la résistance R5, traverse le transistor PUT, le thyristor SCR, la résistance relative R4 de polarisation et la diode LED2.

Dès que le thyristor SCR a été activé par la décharge du condensateur, le passage en état de conduction provoque la décharge du condensateur C2 à travers le circuit ANBA avec un courant limité par la résistance R1 et traversant le thyristor SCR et la diode LED2.

Les composants des circuits de la figure 1 doivent être choisis essentiellement en tenant compte des critères suivants :

- R1 doit avoir une valeur suffisante pour empêcher les pointes de courant trop élevées dans le thyristor SCR pendant la décharge du condensateur C2;

- R2 et R3 doivent avoir des valeurs correspondant à l'exigence de polarisation du transistor unijonction (par exemple R2//R3 = 1MΩ);

- R4 est déterminée par les modalités de fonctionnement du thyristor SCR;

- R5 doit avoir une valeur permettant une décharge du condensateur C3 à travers elle, suffisante pour porter le thyristor SCR en état de conduction et pas trop faible pour ne pas détériorer le thyristor SCR et le transistor unijonction PUT.

- Le transistor unijonction PUT doit avoir un courant de pic et un courant d'entrée de commande suffisamment inférieurs au courant minimum Imin imposé au circuit;

- le thyristor SCR doit avoir des courants de blocage inverse et direct suffisamment inférieurs au courant minimum Imin imposé au circuit.

Les deux décharges consécutives décrites ci-dessus vont, rapidement l'une après l'autre dans la diode LED2, faisant émettre en même temps une impulsion de lumière. De telles impulsions de lumière, sont émises en correspondance avec un même point de la sinusoïde du courant I, pour une même valeur de courant. En choisissant de bonnes valeurs de capacité des condensateurs C2 et C3 du circuit, il est possible de limiter la variation de l'instant d'émission de l'impulsion de lumière par rapport la sinusoïde du signal d'entrée I dans un intervalle de temps Δt suffisamment petit, même si l'intensité du courant d'entrée varie entre des limites (Imin - Imax.) imposées par des oscillations de tension dans un fonctionnement normal de la ligne électrique à tester. Un exemple possible de calcul d'une telle capacité, qui tient compte du champ de variation du courant et de la tension de travail du transistor unijonction PUT, est décrite ci-après.

Si Vak est la tension de travail du transistor unijonction PUT, la tension V dans le circuit doit être de valeur inférieure ou égale à la tension de travail; elle peut s'exprimer par la relation suivante :

$$V \approx \frac{R3}{R2 + R3} \frac{2 \, Imax}{\omega \, CI} \leq V_{AK} \tag{1}$$

où l'on peut retrouver facilement, connaissant I, $\omega$, R2 et R3, le travail de la capacité C2 qui satisfait une telle relation. Une telle valeur est la valeur minimum que peut assimiler la capacité du condensateur en C2.

En fixant ensuite par commodité C2 = C3 = C, le temps t pendant lequel est émise l'impulsion lumineuse à l'intérieur de chaque période est fourni avec une approximation suffisante par la relation suivante :

$$\frac{1}{\omega \, C} \left\{ 1 + e^{-\frac{\pi}{\omega \, C} \frac{1}{(R2 + R3)}} \right\} \frac{R3}{R2 + R3} \, e^{-\frac{t}{C(R2 + R3)}} + 0.5 = \frac{I}{\omega \, C} (1 - \cos \omega t) \tag{2}$$

En insérant dans cette relation les valeurs limites de ce champ de variabilité de I (Imin - Imax), il est possible de déterminer les valeurs correspondantes t(min) et t(max) qui déterminent l'intervalle de temps $\Delta$t. Un tel intervalle de temps peut être aussi petit que possible, en faisant varier la valeur de C.

La valeur de C ainsi définie devient la limite supérieure des valeurs possibles des capacités C2 et C3. Le signal lumineux ainsi obtenu par le circuit PLS est suffisamment intense pour être transmis avec des fibres optiques 4 jusqu'à la position d'accès de l'opérateur. Il en résulte une séparation physique entre l'opérateur et les conducteurs électriques.

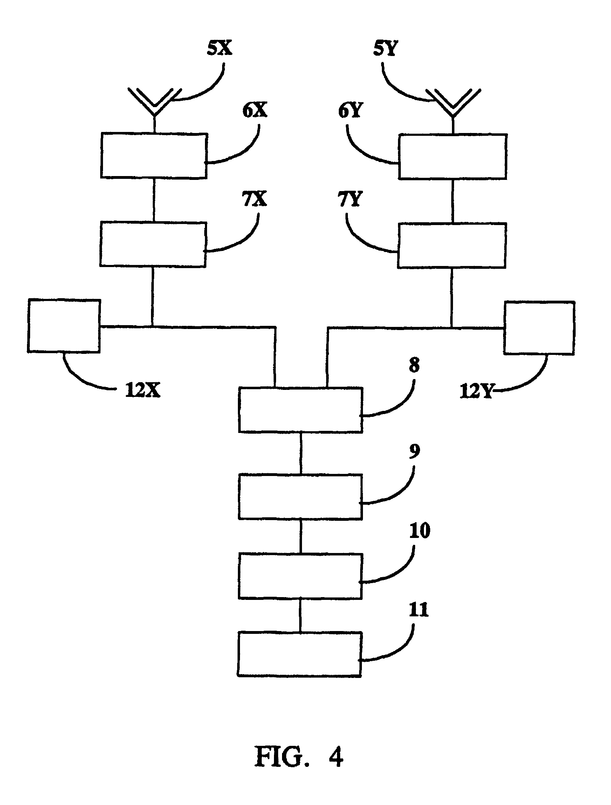

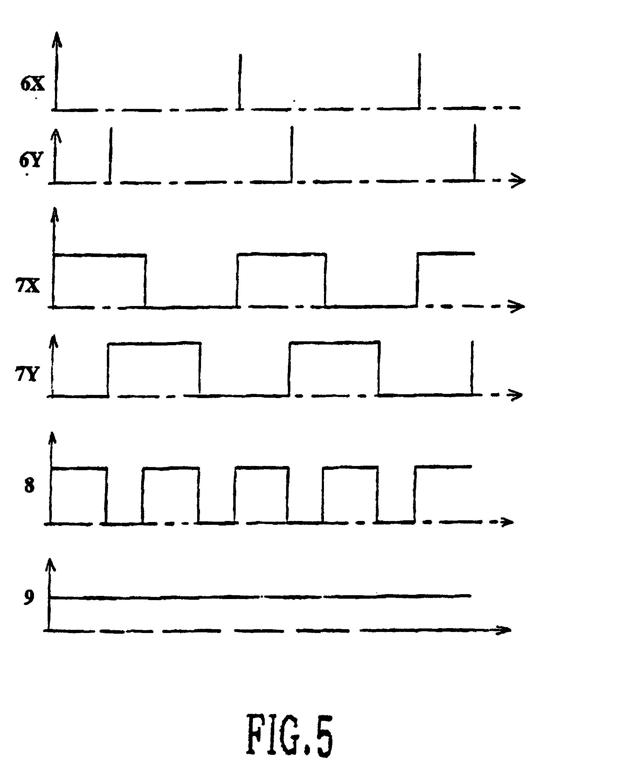

L'information, contenue dans le train de signaux lumineux provenant de la diode LED2, est utilisée pour comparer la phase de deux conducteurs différents. Un dispositif comparateur PSC est employé, lequel est illustré dans le schéma bloc de la figure 4. Dans la figure 5 sont représentés qualitativement, avec les mêmes références numériques, les graphiques des signaux électriques issus des blocs particuliers du dispositif de comparaison PSC. Un tel dispositif, suivant des exigences particulières, peut être monté fixe à l'intérieur de la cabine, dans la zone d'accès et de contrôle d'un opérateur ou être sous la forme d'un instrument portable, en permanence sur l'opérateur. Dans chaque cas, il doit être muni d'une source d'énergie autonome, par exemple une pile électrique.

Selon un mode réalisation de l'invention, le dispositif comparateur de la figure 4 recueille, à travers des connecteurs 5X et 5Y, des trains de signaux lumineux transmis par des circuits PLS associés à deux conducteurs de ligne X et Y auxquels il faut vérifier la phase, en utilisant des câbles à fibres optiques 4. La connexion entre les terminaisons des câbles à fibres optiques et le dispositif comparateur PSC peut être fixe, si le dispositif lui-même est installé fixe dans la cabine électrique ou, de préférence, les connexions sont réalisées au moment de l'utilisation, avec des fiches et des câbles à fibres optiques qui transfèrent le signal à l'intérieur du dispositif comparateur.

Les signaux optiques provenant des connecteurs 5x et 5Y sont envoyés séparément à des blocs respectifs 6X et 6Y constitués par des éléments photosensibles qui transforment les impulsions lumineuses en impulsions électriques d'une durée de quelques dizaines de micro secondes. La durée de tels signaux est ensuite avantageusement prolongée, par exemple jusqu'à une durée égale à la moitié de la période du signal lui-même, au moyen de deux multivibrateurs monostables 7X et 7Y.

Les impulsons électriques, ainsi modifiées, sont enfin envoyées à un bloc fonctionnel 8 capable de comparer les signaux d'entrée des blocs 7X et 7Y et produisant en sortie un train d'impulsions dont la durée est proportionnelle au déphasage entre les signaux 7X et 7Y. La durée des signaux sortant du bloc 8 à l'intérieur de chaque période particulière sera ainsi proportionnelle au déphasage entre les signaux provenant de 7X et 7Y. Le bloc 8 peut être par exemple construit avec des portes OU exclusif (EXOR) ou des portes ET NON **(NAND).**

Le signal de sortie du bloc 8 est intégré dans un stabilisateur 9 qui fournit sur sa sortie une tension continue de valeur proportionnelle à la durée, dans la période du signal sortant du bloc 8 et donc proportionnelle au déphasage entre les signaux issus des blocs 7X et 7Y.

De telles tensions sont, appliquées à l'entrée d'un comparateur 10 qui enverra une sortie haute ou respectivement basse, suivant que la valeur de la sortie est supérieure ou inférieure à une valeur de seuil prédéterminée. La sortie basse signifie que les conducteurs électriques testés sont en phase, alors qu'une sortie haute signifie que les mêmes conducteurs ne sont pas en phase. L'état de cette sortie peut être convenablement rendue visible au moyen d'un indicateur lumineux 11. Le dispositif peut être complété par des indicateurs lumineux 12X et 12Y, connectés aux sorties respectivement des monostables 7X et 7Y, pour indiquer la présence au moins des signaux d'entrée du dispositif venant des connecteurs 5X et 5Y.

La présence des circuits TCS et PLS permet d'obtenir des signaux lumineux qui correspondent respectivement à la présence de tension sur les conducteurs et représentatifs de la phase de leurs tensions. Ces signaux ont en outre une intensité suffisamment élevée - nonobstant l'absence d'une source autonome d'alimentation - pour être transmis, via un câble à fibres optiques, jusqu'à une distance convenable de sécurité, et aussi jusqu'à un endroit commode pour l'accès de l'opérateur.

En particulier, avec un signal provenant du circuit PLS, il est possible d'effectuer des comparaisons de phase entre deux divers conducteurs de manière particulièrement simple, grâce au fait que ledit signal est toujours émis en correspondance avec une zone réduite de la sinusoïde (correspondant à un intervalle de temps $\Delta t$) indépendant des possibles variations de la tension du réseau et donc bien représentatif de la phase du signal lui-même.

**Revendications**

1.  Dispositif électronique pour vérifier, à une distance de sécurité, la présence de tension et le déphasage de tension dans des conducteurs (X, Y) de lignes électriques à courant alternatif comprenant:

    -   au moins deux dispositifs (1) capacitifs couplés à aux moins deux desdits conducteurs électriques, chaque dispositif capacitif fournissant un courant alternatif (I) à très basse intensité ayant la même fréquence que le signal de tension du conducteur auquel il est couplé,
    -   des circuits de détection de phase (PLS) auto alimentés, chaque circuit étant connecté à un desdits dispositifs capacitifs associé, et fournissant une impulsion lumineuse pour chaque période du signal provenant dudit dispositif capacitif associé.
    -   des câbles (4) à fibres optiques comportant chacun une première extrémité reliée à un desdits circuits de détection de phase, aptes à transmettre lesdites impulsions lumineuses dans une zone de sécurité, éloignée des conducteurs électriques; et
    -   au moins un dispositif (PSC) de comparaison du déphasage, connecté à des secondes extrémité desdits câbles à fibres optiques, pour comparer des impulsions lumineuses émises par deux différents circuits détecteurs de phases,

    **caractérisé en ce que** chaque circuit de détection de phase (PLS) comporte:

    -   des moyens de redressement (D1, D2, D3, D4) traversés par le courant (I) fourni par les dispositifs capacitifs, et formant un pont redresseur à deux branches,
    -   un premier condensateur (C2) connecté dans l'une des branches entre deux moyens de redressement (D1, D2), et susceptible d'être chargé pendant la demi-période négative du courant d'entrée,
    -   un second condensateur (C3) connecté dans l'autre branche entre deux moyens de redressement (D3, D4), et susceptible d'être chargé pendant la demi-période positive du courant d'entrée,
    -   des moyens de contrôle pour activer, à un instant prédéterminé de la période dudit courant, la décharge d'au moins un desdits condensateurs à travers une diode électroluminescente (LED2), lesdits moyens de contrôle comprenant un thyristor (SCR) connecté en série avec la diode électroluminescente (LED2) aux bornes du premier condensateur (C2), et un transistor unijonction (PUT) branché entre le thyristor (SCR) et l'une des bornes du second condensateur (C3).

2.  Dispositif électronique selon la revendication 1, **caractérisé en ce que** le transistor unijonction (PUT) est actionné par un potentiel différentiel existant entre lesdits deux condensateurs.

3.  Dispositif électronique la revendication 1, **caractérisé en ce que** la décharge activée sur le premier condensateurs (C2) active la décharge du second condensateur (C3) au moyen dudit thyristor (SCR).

4.  Dispositif électronique selon la revendication 1 **caractérisé en ce que** ledit dispositif de comparaison (PSC) comporte :

    -   deux entrées (5X, 5Y),

    -   deux dispositifs (6X, 6Y) photosensibles, reliés chacun à une entrée, pour transformer les impulsions lumineuses d'entrée en signaux électriques correspondants,

    -   deux multivibrateurs (7X, 7Y) monostables, connectés aux dispositifs photosensibles, pour allonger la durée desdits signaux électriques correspondants,

- un circuit logique (8), connecté aux multivibrateurs monostables, pour obtenir un signal ayant une durée proportionnelle à la différence de phase desdits deux signaux,

- un stabilisateur (9), connecté au circuit logique, pour intégrer ledit signal représentatif de la différence de phase et fournir un signal continu, et

- un comparateur (10), connecté au stabilisateur, pour comparer ledit signal continu avec un seuil de référence.

5. Dispositif électronique selon la revendication 4, **caractérisé en ce que** ledit dispositif de comparaison comprend un indicateur lumineux (11) pour indiquer la concordance de phase entre les signaux reçus par les entrées (5X, 5Y), et des moyens de visualisation (12X, 12Y) de la présence de tension, connectés aux sorties des multivibrateurs monostables (7X, 7Y).

6. Dispositif électronique selon l'une quelconque des revendications 1 à 5, **caractérisé en ce qu'**il comporte

- des circuits (TLS) de détection de présence de tension connectés à des dispositifs capacitifs (1) et fournissant des impulssions lumineuses, et

- des câbles (2) à fibres optiques comportant chacun une première extrémité reliée à un desdits circuits de détection de présence de tension, aptes à transmettre lesdites impulsions lumineuses dans une zone de sécurité, éloignée des conducteurs électriques.

**Claims**

1. An electronic device for checking, at a safety distance, the presence of voltage and the voltage phase difference in conductors (X, Y) of AC electrical lines comprising:

- at least two capacitive devices (1) coupled to at least two of said electrical conductors (X, Y), each capacitive device supplying a very low intensity alternating current (1) having the same frequency as the voltage signal of the conductor to which it is coupled,
- system-supplied phase detection circuits (PLS), each circuit being connected to one of said associated capacitive devices, and supplying a light pulse for each period of the signal coming from said associated capacitive device,
- optic fibre cables (4) each comprising a first end connected to one of said phase detection circuits, able to transmit said light pulses to a safety zone away from the electrical conductors; and
- at least one phase difference comparison device (PSC) connected to second ends of said optic fibre cables to compare light pulses emitted by two different phase detection circuits,

**characterized in that** each phase detection circuit (PLS) comprises:

- rectifying means (D1, D2, D3, D4) through which the current (I) supplied by the capacitive devices flows, and forming a rectifier bridge with two branches,
- a first capacitor (C2) connected in one of the branches between two rectifying means (D1, D2) and able to be charged during the negative half-period of the input current,
- a second capacitor (C3) connected in the other branch between two rectifying means (D3, D4) and able to be charged during the positive half-period of the input current,
- control means to activate, at a preset moment of the period of said current, discharge of at least one of said capacitors through a light-emitting diode (LED2), said control means comprising a thyristor (SCR) connected in series with the light-emitting diode (LED2) to the terminals of the first capacitor (C2), and a unijunction transistor (PUT) connected between the thyristor (SCR) and one of the terminals of the second capacitor (C3).

2. The electronic device according to claim 1, **characterized in that** the unijunction transistor (PUT) is actuated by a differential potential existing between said two capacitors.

3. The electronic device according to claim 1, **characterized in that** the discharge activated on the first capacitor (C2) activates discharge of the second capacitor (C3) by means of said thyristor (SCR).

**4.** The electronic device according to claim 1, **characterized in that** said comparison device (PSC) comprises:

- two inputs (5X, 5Y),
- two photosensitive devices (6X, 6Y), each connected to an input, to transform the input light pulses into corresponding electrical signals,
- two monostable multivibrators (7X, 7Y) connected to the photosensitive devices, to lengthen the duration of said corresponding electrical signals,
- a logic circuit (8) connected to the monostable multivibrators, to obtain a signal having a duration proportional to the phase difference of said two signals,
- a stabiliser (9) connected to the logic circuit, to integrate said signal representative of the phase difference and to supply a DC signal, and
- a comparator (10) connected to the stabiliser, to compare said DC signal with a reference threshold.

**5.** The electronic device according to claim 4, **characterized in that** said comparison device comprises a light indicator (11) to indicate phase coincidence between the signals received by the inputs (5X, 5Y), and voltage presence display means (12X, 12Y) connected to the outputs of the monostable multivibrators (7X, 7Y).

**6.** The electronic device according to any one of the claims 1 to 5, **characterized in that** it comprises:

- voltage presence detection circuits (TLS) connected to capacitive devices (1) and supplying light pulses, and
- optic fibre cables (2) each comprising a first end connected to one of said voltage presence detection circuits, able to transmit said light pulses to a safety zone away from the electrical conductors.

**Patentansprüche**

**1.** Elektronische Anordnung, die dazu dient, aus einer Sicherheitsentfernung Leiter (X, Y) von elecktrischen Wechselstromleitungen auf das Anstehen einer Spannung sowie auf Spannungsphasendifferenzen zu überprüfen, und die

- mindestens zwei kapazitive Anordnungen (1), die an mindestens zwei der genannten elektrischen Leiter angekoppelt sind, wobei jede kapazitive Anordnung einen Wechselstrom (I) sehr geringer Stärke liefert, der die gleiche Frequenz aufweist, wie das Spannungssignal des Leiters, an den er angekoppelt ist,
- Phasenerfassungsschaltungen (PLS) mit Eigenstromversorgung, die jeweils mit einer der zugeordneten kapazitiven Anordnungen verbunden sind und für jede Periode des von der genannten, zugeordneten kapazitiven Anordnung gelieferten Signals einen Lichtimpuls liefern,
- Lichtleiterkabel (4), die jeweils ein, mit einer der genannten Phasenerfassungsschaltungen verbundenes erstes Ende aufweisen und in der Lage sind, die genannten Lichtimpulse in einen, von den elektrischen Leitern entfernt angeordneten Sicherheitsbereich zu übertragen, sowie
- mindestens eine Phasenvergleichsanordnung (PSC) umfaßt, die an zweite Enden der genannten Lichtleiterkabel angeschlossen ist, um die von zwei verschiedenen Phasenerfassungsschaltungen ausgesendeten Lichtimpulse miteinander zu vergleichen,

**dadurch gekennzeichnet, daß** jede Phasenerfassungsschaltung (PLS)

- Gleichrichtmittel (D1, D2, D3, D4), die von dem durch die kapazitiven Anordnungen gelieferten Strom (I) durchflossen werden und einen Zweiweg-Brückengleichrichter bilden,
- einen ersten Kondensator (C2), der in einen der Zweige zwischen zwei Gleichrichtmittel (D1, D2) geschaltet ist und dazu dient, während der negativen Halbwelle des Eingangsstroms aufgeladen zu werden,
- einen zweiten Kondensator (C3), der in den anderen Zweig zwischen zwei Gleichrichtmittel (D3, D4) geschaltet ist und dazu dient, während der positiven Halbwelle des Eingangsstroms aufgeladen zu werden,
- sowie Steuermittel umfaßt, die dazu dienen, zu einem bestimmten Zeitpunkt der Periodendauer des genannten Stroms die Entladung mindestens eines der genannten Kondensatoren über eine Lumineszensdiode (LED2) zu bewirken, wobei die genannten Steuermittel einen in Reihe mit der Lumineszensdiode (LED2) an die Klemmen des ersten Kondensators (C2) geschalteten Thyristor (SCR) sowie einen zwischen den Thyristor (SCR) und eine der Klemmen des zweiten Kondensators (C3) geschalteten Unijunction-Transistor (PUT) umfassen.

**2.** Elektronische Anordnung nach Anspruch 1, **dadurch gekennzeichnet, daß** der Unijunction-Transistor (PUT) durch eine zwischen den beiden genannten Kondensatoren bestehende Potentialdifferenz gezündet wird.

3. Elektronische Anordnung nach Anspruch 1, **dadurch gekennzeichnet, daß** die Entladung des ersten Kondensators (C2) über den genannten Thyristor (SCR) die Entladung des zweiten Kondensators (C3) bewirkt.

4. Elektronische Anordnung nach Anspruch 1, **dadurch gekennzeichnet daß** die genannte Vergleichsanordnung (PSC)

   - zwei Eingänge (5X, 5Y),

   - zwei optoelektronische Schaltungen (6x, 6Y), die jeweils mit einem Eingang verbunden sind, um die Eingangslichtimpulse in entsprechende elektrische Signale umzuwandeln,

   - zwei an die optoelektronischen Schaltungen angeschlossene monostabile Multivibratoren (7X, 7Y) zur Verlängerung der Dauer der genannten elektrischen Signale,

   - eine an die monostabilen Multivibratoren angeschlossene Logikschaltung (8) zur Erzeugung eines Signals, dessen Dauer der Phasenabweichung zwischen den beiden genannten Signalen proportional ist,

   - einen an die Logikschaltung angeschlossenen Stabilisator (9) zur Integration des genannten, die Phasenabweichung abbildenden Signals und zur Ausgabe eines kontinuierlichen Gleichspannungssignals sowie

   - einen an den Stabilisator angeschlossenen Komparator (10) zum Vergleich des genannten Gleichspannungssignals mit einem Bezugsschwellwert umfaßt.

5. Elektronische Anordnung nach Anspruch 4, **dadurch gekennzeichnet, daß** die genannte Vergleichsanordnung einen Leuchtmelder (11) zur Anzeige der Phasengleichheit zwischen den an den Eingängen (5X, 5Y) empfangenen Signalen sowie an die Ausgänge der monostabilen Multivibratoren (7X, 7Y) angeschlossene Visualisierungsmittel (12X, 12Y) zur Anzeige des Anstehens einer Spannung umfaßt.

6. Elektronische Anordnung nach irgendeinem der Ansprüche 1 bis 5, **dadurch gekennzeichnet, daß** sie

   - Spannungsnachweisschaltungen (TLS), die an kapazitive Anordnungen (1) angeschlossen sind und Lichtimpulse liefern,

   sowie Lichtleiterkabel (2) umfassen, die jeweils ein, mit einer der genannten Spannungsnachweisschaltungen verbundenes erstes Ende aufweisen und in der Lage sind, die genannten Lichtimpulse in einen, von den elektrischen Leitem entfernt angeordneten Sicherheitsbereich zu übertragen.

FIG. 1

FIG.2

FIG.3

EP 0 635 725 B1

FIG. 4

FIG.5